Europäisches Patentamt

**European Patent Office**

Office européen des brevets

(19)

(11) Publication number: **0 254 201**
A1

(12)

# EUROPEAN PATENT APPLICATION

(21) Application number: **87110236.4**

(22) Date of filing: **15.07.87**

(51) Int. Cl.³: **C 25 D 5/10**
**C 23 F 1/16, C 23 C 22/78**
**C 04 B 41/88, H 05 K 3/18**

(30) Priority: **24.07.86 US 889678**

(43) Date of publication of application:
**27.01.88 Bulletin 88/4**

(84) Designated Contracting States:
**DE FR GB**

(71) Applicant: **Zsamboky, Kalman F.**
**14900 County Road 79**
**Elk River Minnesota 55330(US)**

(72) Inventor: **Zsamboky, Kalman F.**
**14900 County Road 79**
**Elk River Minnesota 55330(US)**

(74) Representative: **Schwan, Gerhard, Dipl.-Ing.**
**Elfenstrasse 32**
**D-8000 München 83(DE)**

(54) **Method of metallizing ceramic substrates.**

(57) A method of depositing a metal on a surface, comprising the steps of exposing the surface to an acid etchant; exposing the surface to an alkaline solution containing palladium; exposing the surface to an electroless bath to deposit a layer of metal on the surface; and electroplating onto the metal on the surface an additional metal layer. In addition, the metal on the surface may be exposed to a solution of citric acid and sulfuric acid to make the metal tarnish-resistant.

EP 0 254 201 A1

## METHOD OF METALLIZING CERAMIC SUBSTRATES

## BACKGROUND OF THE INVENTION

### 1. Field of the Invention.

This invention discloses a method of metallizing a ceramic substrate, and in particular, a method of applying a copper layer to a ceramic substrate using electroless deposition.

### 2. Description of the Prior Art.

In order to make printed circuit assemblies and hybrid circuits, it is often necessary to metallize a substrate with a conductive metal such as copper so that metallized conductor patterns can be formed. By coating the substrate with a metal such as copper, conventional plating with other metals, such as nickel or gold, can follow.

In order to produce hybrid circuits, a ceramic substrate is often used. In the past, the ceramic substrate has been metallized using high cost processes such as fused metal-glass pastes and thin film vacuum deposition techniques. Past attempts to produce circuit patterns by direct electroless deposition have been unsuccessful due to poor adhesion of the metal film to the substrate and non-reproducible and non-uniform surface coverage.

A thin film circuit on ceramic typically consists of a thin film of metal deposited on a ceramic substrate by one of the vacuum deposition techniques. In these techniques, generally a chromium or molybdenum film, having a thickness of about 0.02 $\mu$m, acts as a bonding agent for copper or gold layers. Photolithography is used to produce high resolution patterns by etching away the thin metal film. Such conductive patterns may be electroplated up to, typically, 7 $\mu$m thick.

- 2 -

However, due to their high costs, thin film circuits have been limited to specialized applications such as high frequency and military applications where a high pattern resolution is vital.

Another method of producing printed circuits is known as thick film circuit. A thick film circuit comprises a conductor pattern consisting of a metal and glass film fired on a ceramic substrate. Typically, the film has a thickness of about 15 $\mu$ m. Thick film circuits have been widely used and are produced by screen printing in a circuit pattern with a paste containing a conductive metal powder and a glass frit in an organic carrier. After printing, the ceramic parts are fired in a furnace to burn off the carrier and sinter the conductive metal particles and fuse the glass. These conductors are firmly bonded to the ceramic by the glass and thus components may be attached to the conductors by soldering, wire bonding and the like.

A disadvantage in using thick film circuits is that the conductors have only a 30-60 percent of the conductivity of the pure metal. In general, there is a need of the high conductivity of the pure metal in order to provide the necessary interconnections for high speed logic circuits.

Another disadvantage with regard to thick film circuits is that the minimum conductor width and minimum space between conductors which can be obtained by screen printing and firing under these procedures is generally 125 and 200 $\mu$ m, respectively, under special high quality procedures. However, under normal production conditions, these

0413j

22G86

minima are 200 and 250 $\mu$m, respectively. In addition, thru-hole coverage is poor due to the inability of the paste to conform readily to the internal characteristics of the holes.

For ceramic surface requiring higher interconnection density, multi-layer techniques must often be used. In order to produce thick film multi-layer circuits, a first layer of metal powder and glass frit is printed on a ceramic substrate and fired, typically at 850°C. Subsequently, an insulating dielectric layer is screened over the conductor pattern, leaving exposed only the points at which contact is to be made to the next layer of metalization. This dielectric pattern is also fired at approximately 850°C and this procedure is repeated to produce second and subsequent conductive pattern layers upon which second and subsequent dielectric layers are formed until the desired number of layers have been produced.

Attempts have been made in the past to directly bond pure metal conductors to ceramic substrates including alumina in order to achieve higher conductivity for ceramic-based circuit patterns. For example, U.S. Patent No. 3,994,430 to Cusano et al. describes a process which involves bonding copper sheets to alumina by heating the copper in air to form an oxide layer on its surface. The prepared copper sheet is then bonded to the alumina at a temperature between 1065°C and 1075°C in a nitrogen furnace. However, in order to produce a well adhered copper foil without blisters, the process parameters have to be controlled very closely, which is hard to do under commercial operating conditions.

- 4 -

Although the above described metallization systems have been commercially used, the need for direct, simple metallization of ceramics for producing pure metal conductors, such as copper, has prompted a continuing series of patents and proposed processes. For example, U.S. Patent 3,296,012 to Stalnecker, Jr. discloses a method of producing a microporous surface for electrolessly plating alumina.

U.S. Patent 3,690,921 to Elmore involves the use of molten sodium hydroxide to etch a ceramic surface. In this process, subsequently, sodium hydroxide is rinsed from the ceramic surface with water, the ceramic surface neutralized with dilute sulfuric acid and rinsed again before sensitizing with a stannous chloride solution, rinsing and seeding with a palladium chloride solution, to catalyze the surface for electroless metal plating.

Although a metal film deposit with relatively good bond strength was achieved by the process of Elmore, it did not reach acceptance for commercial production due to the poor surface coverage by the electrolessly deposited metal. Although the metal deposit usually covered 90 percent of the surface area or even more, this was unacceptable since any imperfection in the foreign metal film may cause defective circuit conductors and a failure of such imperfection occurs in a fine line conductor pattern.

U.S. Patent 4,428,986 to Schachameyer discloses a method for direct autocatalytic plating of a metal film on beryllia. The method comprises roughening the surface of the beryllia by immersing

- 5 -

in a 50 percent sodium hydroxide solution, rinsing with water, etching the beryllia substrate with fluoroboric acid, rinsing with water, immersing it in a solution of 5 g/l stannous chloride and 3N hydrochloric acid, rinsing with water, treating the beryllia surface with a 0.1 g/l palladium chloride solution, rinsing with water and then electrolessly plating nickel on the beryllia. When depositing copper metal on a ceramic substrate, the strength of the copper-ceramic bond is very important. This is because if the adhesion between the two substances is weak, the copper may peel off of the ceramic in normal use, thus rendering the component worthless. In the etching step of Schachameyer, silica and magnesium are removed from the grain boundaries of the beryllia thereby weakening the beryllia surface and as a result, the method of this patent was able to achieve only 1.7 MPascal bond strength before the beryllia substrate broke. This bond strength is too low for practical use required for thick film type circuits.

The prior art processes described were therefore unreliable as they resulted in incomplete surface coverage with or unacceptably low bond strength of a formed metal deposit, or both, and are therefore unsatisfactory for commercial production purposes.

## SUMMARY OF THE INVENTION

The present invention is a method of depositing a metal on a surface, comprising the steps of exposing the surface to an acid etchant; exposing the surface to an alkaline solution containing palladium; exposing the surface to an electroless bath to deposit a layer of metal on the surface; and

0413j                                          22G86

- 6 -

electroplating onto the metal on the surface an additional metal layer. The concentration of palladium in the bath may be lower than typically used. In addition, the metal on the surface may be exposed to a solution of citric acid and sulfuric acid to make the metal tarnish-resistant.

DETAILED DESCRIPTION OF THE PREFERRED EMBODIMENTS

The present invention is a method for depositing a metal on a surface. In particular, the method is useful in depositing a layer of copper on a ceramic substrate using electroless deposition techniques.

The present invention deposits metal on a substrate such as a ceramic blank, or porcelainized metal such as ELPOR II by Ferro Corp. (Ohio) which is referred to as a substrate. Examples of ceramic substrates include aluminum oxide, alumina, beryllium oxide, beryllium titanate and ferrite, or other substrates having similar characteristics. In addition, a product sold by Corning Glass Works (New York) under the name Photoceran may be used as a substrate.

In order to configure the ceramic blank as desired for the final hybrid circuit, the blank is machined with a laser in order to produce the desired lines, holes, and other surface characteristics.

After the ceramic substrate has been laser machined, it is placed in a kiln in order to slowly raise the temperature of the ceramic substrate to approximately 1700° F. This temperature is maintained for thirty to forty minutes in order to clean the substrate, and then the ceramic substrate is allowed to cool down slowly. This process may take a full day.

0413j                                                    22G86

- 7 -

In order to initiate the actual deposition of the metal onto the ceramic substrate, the ceramic blank is heated to 200° F for approximately five to ten minutes. The preheated blank is then dipped into a heated concentrated acid dip. Preheating the substrate lessens the thermal shock which the ceramic substrate undergoes when exposed to the heated acid.

The acid dip etches the surface of the ceramic substrate in order to remove any unwanted glasseous states of ceramic which may have been produced by the laser machining step. This tends to condition the surface, and also roughens the surface for better adhesion of the deposited metal. For best results, the concentrated acid is heated to near its boiling point so that the etching may take place more rapidly.

The acid dip is selected from those acid etchants capable of etching glass, alumina, silica or any of the other ceramic and procelain substrates. For example, the acid etchant may be any acid from the halogen family, i.e., fluorine, chloride, bromine iodine or astatine. In addition, other acid etchants which may be utilized include phosphoric acid, nitric acid, permanganic acid, or any inorganic acid.

. After being dipped in the concentrated acid, the ceramic substrate is allowed to cool to room temperature, which takes approximately fifteen to twenty minutes. The substrate is then rinsed with water and put into a rack for holding the substrate during further processing.

The ceramic substrate is next subjected to a number of conditioning and cleaning steps in order to properly prepare the surface of the substrate for the deposition of the metal. One such solution which

0413j                                          22G86

- 8 -

conditions the substrate is an ammonium bifluoride solution. Dipping the substrate in this solution helps condition the surface of the ceramic substrate. The ammonium biflouride solution is followed by a deionized water rinse step.

Another conditioner is fluoboric acid dip which includes a wetting agent. The wetting agent helps to maintain proper coverage of the other solutions on the substrate. This fluoboric acid dip is similarly followed by a deionized water rinse step.

After the blank has been dipped in either the ammonium biflouride solution and/or the fluoboric acid solution, it is often desirable to condition and clean the substrate in a cleaner solution with a sodium hydroxide base. This alkaline cleaner conditioner helps to neutralize the strong acids used in the previous cleaning conditioner baths, and also acts as wetting agent in order to further prepare the surface for metal deposition.

Next, the ceramic substrate is exposed to a cleaner with a neutral pH with an added wetting agent. After this cleaner condition, the substrate is rinsed in deionized water.

The ceramic blank is next dipped into a sodium persulfate in water solution. This sodium persulfate solution acts as an etchant for any copper which may have remained on the rack from earlier processing steps. The substrate is then rinsed with deionized water.

After performing the above cleaning and conditioning steps, the ceramic substrate is now properly prepared to begin the steps necessary for the deposition of metal. The first of the steps is

0413j                                                          22G86

to introduce the ceramic substrate into a pre-dip solution containing a conditioner and wetting agent to prepare the surface.

After the pre-dip solution, the ceramic substrate is dipped into an activator solution. In the present method, an ionic palladium activator solution is used. A copper activator solution produced by LeaRonal, Inc. (New York) may also be used.

The palladium solution used in the present invention is different than typical palladium solutions in that the present invention uses an alkaline palladium solution with a pH above 7. Such alkaline solutions usually contain an alkali, such as NaOH, KOH, LiOH or other metal hydroxides. Previous methods of depositing metal such as copper, called for a highly acidic palladium and tin solution in which the palladium was in colloidal form. In the past, tin was deposited on the substrate first and then the palladium. Thereafter, the tin was etched. However, in the present invention, by using an alkaline palladium solution, there is no tin in the solution and there is no corresponding tin etch. This allows the palladium to be deposited directly on the surface of the substrate without the possibility of disturbing the palladium when etching the tin.

The palladium solution of the present invention also differs from prior art palladium solutions used in that the concentration of palladium is much lower than previous solutions. In the present invention, palladium concentration of approximately 50 to 200 ppm palladium is used, with the optimum palladium concentration being about 150

- 10 -

ppm, with the result that a thin layer of palladium is deposited on the substrate. Thereafter, the ceramic substrate is rinsed.

It has been found that if a higher palladium concentration is utilized, the copper deposited on the substrate may blister. This is believed to be caused by the electroless copper adhering too quickly to too many sites, thus allowing blisters and other unwanted surface characteristics to form.

After the ceramic substrate has been dipped into the palladium activator to deposit a thin layer of palladium on the surface of the ceramic substrate, the substrate is dipped into a reducing solution which reduces the palladium from its ionic state of $Pd^{2+}$ to Pd metal. The ceramic substrate is then dipped in a weaker reducing solution in order to allow drag-in into the next bath.

The ceramic substrate is next placed into an electroless metal bath. In the electroless bath, the desired metal ions are attached to the palladium metal ions. The electroless metal used in most cases is electroless copper, which is quite conductive, although electroless nickel, tin, gold, among others will work. In the present invention, the electroless bath is conventional except for the fact that the copper concentration is lower than that typically utilized. This results in a very slow deposition rate of the electroless copper so that the grains will be very close together and result in a tight and strong copper layer. The copper is deposited at a rate of approximately 0.000020 inch in thirty minutes.

The electroless bath also contains: formaldehyde, which acts as a reducing agent for the cupric ions; sodium hydroxide, which acts as a pH adjuster; stabilizers; cyanide; and EDTA (ethylenediaminetetracetic acid $(C_{10}H_{16}N_2O_8)$) which acts as a complexing agent. The copper concentration in the bath may be approximately 1 to 2 g/l with the optimum concentration being approximately 1.5 g/l. After the electroless bath, the substrate is then rinsed with deionized water.

Next, the substrate is once again returned to the pre-dip and the palladium solution where it is once again re-activated. The reducing step and the electroless copper deposition steps are also repeated. The substrate is cycled through the activator, reduction and electroless copper baths approximately twice more, or until the total copper thickness required has been deposited. Usually the total electroless copper required is between 0.000040 and 0.000050 inches. After the substrate has been processed through the activation, reducing and electroless steps the desired number of times, it is rinsed with deionized water.

An important step after the copper is deposited on the substrate is to dip the substrate into citric acid/sulfuric acid dip. This citric/sulfuric dip renders the deposited copper tarnish resistant. Copper is active with oxygen and the metallized substrate would tarnish quickly upon exposure to air without such treatment. The citric acid/sulfuric acid reacts with the deposited copper layer to create a citric cupric layer which is not as susceptible to oxidation. By performing this step, the ceramic substrates with the deposited metal may be dried and stored for a period of time, if desired.

0413j                                                          22G86

In order to prepare the ceramic substrate for further processing steps, the substrate is baked at approximately 250° F in order to evaporate any moisture which might be entrapped within the deposited copper layer. This entrapped moisture must be removed before any further processing, such as electroplating, so that blistering of the metal layer will not occur.

The substrate with its deposited metal is next dipped into a cleaner solution to remove any fingerprints, oxides or other surface contaminants which may have been introduced to the surface during processing. This also reactivates the surface for electroplating. After the cleaning solution, the ceramic substrate is rinsed.

The ceramic substrate is then dipped into a ten percent acid dip as a predip for drag-in into the first of two electroplating baths. In the method of the present invention, the ceramic substrate with the electroless copper deposited thereon is introduced into copper electroplating baths with differing chemistries. The first plating bath is an acid electroplating bath which contains no brighteners.

Brightners are organic materials act as grain refiners for the electroplated metals. The brightners cause the metal grains to be smaller, which causes the surface of the deposited metal to appear shiny.

The effect of having no brighteners in the first plating solution is that a layer of relatively denser or "less spongy" copper is deposited directly over the relatively low density or "spongy" copper which was deposited via the electroless copper solution. In the second electroplating bath,

- 13 -

brighteners are included, which causes a layer of copper which is denser, or "tighter" than the layer of "less spongy" copper deposited in the first plating bath, to be deposited.

The use of two eletroplating baths, the first without brighteners, is important because the "less spongy" copper forms a cushion between the "spongy" electroless copper and the very dense, "tight" copper deposited in the second electroplating bath. In addition, the second electroplating bath has a lower copper concentration and a higher sulfuric acid solution in order to allow the second electroplating bath to enhance the throwing power through the holes of the substrate.

After the ceramic substrate has been processed in both of the electroplating baths, the substrate is then spray rinsed and dipped into a citric acid/sulfuric acid solution in order to once again make the metal layer tarnish resistant. The ceramic substrate is then rinsed and dried.

In order to prepare the substrate and its metal layers for further processing, the substrate may be fired in a furnace to a temperature which is close to the melting point of the metal. This firing improves adhesion of the metal to the ceramic. In the case of copper on ceramic, this firing results in a pull strength of approximately 10 to 15 pounds per 100 mil pad size. This pull strength is usually required in order to produce acceptable fine lines. The ceramic substrates are fired in the furnace using nitrogen gas ($N_2$) as a cover gas with 10 to 15 ppm oxygen gas ($O_2$) in the furnace. The oxygen gas reacts with the deposited copper to form cuprous

- 14 -

oxide, which chemically bonds to the ceramic with greater adhesion.

After completing these steps as outlined above, the ceramic substrate may then be processed by conventional methods, such as by photo imaging the desired pattern onto the copper covered substrate and electroplating copper, nickel and gold, or other desired metals, on the substrate. Any photoresist used to image the desired patterns on the substrate may then be stripped and any exposed copper etched in order to form the desired patterns.

The following example is given for illustration purposes only and is not intended to limit the present invention in any way.

EXAMPLE

A ceramic substrate blank was slowly raised in a kiln to a temperature of 1700°F for 30 to 40 minutes and allowed to slowly cool down. This process took a full day. The ceramic substrate was then preheated to 200°F for 5 to 10 minutes in order to prepare the substrate to be dipped in a concentrated phosphoric acid solution at 350°F (near the boiling point of the phosphoric acid solution) without experiencing severe thermal shock. The ceramic substrate was dipped into the phosphoric acid solution for approximately five minutes in order to condition the surface and to remove any residue left from the laster machining, such as unwanted glasseous forms of ceramic. The substrate was then allowed to cool to room temperature, approximately 15 to 20 minutes. The substrate was then rinsed in a water bath and put into a rack for further processing.

The ceramic substrate was then dipped into an ammonium bifluoride solution at approximately 120°F for approximately five minutes in order to condition the surface. The ammonium bifluoride solution had a concentration of approximately two pounds of ammonium bifluoride crystals per gallon of water. After being removed from the ammonium bifluoride solution, the ceramic substrate was rinsed for two minutes in deionized water.

The ceramic substrate was next dipped into a fluoroboric acid solution with a wetting agent called Depoison Solution manufactured by Schering, AG., (West Germany) at approximately 120°F for five minutes. This fluoroboric acid dip acted as a surface conditioner and thereafter the ceramic substrate was once again rinsed in deionized water for approximately two minutes.

The ceramic substrate was next introduced into a cleaner conditioner with a sodium hydroxide base. Noviganth Cleaner HC manufactured by Schering, AG (West Germany) was used in order to neutralize the acids from the previous two conditioning baths and to further prepare the surface. The substrate was dipped in this cleaner at approximately 120°F for five minutes. Once again, the ceramic substrate was rinsed with deionized water for approximately two minutes. If desired, this cleaner could also be used in an acid form with 10 ml $H_2SO_4/l$.

The ceramic substrate was next introduced into a cleaner with a neutral pH, such as Securagenth 902 with B23 additive (Schering AG) to act as a wetting agent for five minutes at approximately 120°F. Thereafter, the ceramic substrate was rinsed with deionized water for approximately two minutes.

0413j                                                     22G86

- 16 -

The ceramic substrate was then dipped into a sodium persulfate solution for approximately 30 seconds to etch any copper from the rack and to further condition the surface of the substrate. Thereafter, the substrate was rinsed for two minutes in deionized water.

Before introduction into a palladium activator solution, the ceramic substrates were dipped into a predip solution which acted as a conditioner and wetting agent to prepare the surface for the palladium. The ceramic substrate was dipped in a Neoganth VT (Schering AG) solution for one minute and then introduced into the palladium solution. The palladium solution used in this example was Neoganth Activator 834 (Schering AG), to which the substrate was exposed for approximately six minutes at 90°F. The manufacturer's recommended parameters were to expose the substrate to the solution between room temperature and 110°F for between 3 to 10 minutes. The palladium solution used had a low concentration of palladium, approximately 150 ppm of palladium. The manufacturer recommended a concentration of palladium of 200 ppm for normal printed circuit use. However, this concentration has been found to cause blistering when used in the present process. If desired, the palladium activator XR-074A by Sel-Rex (OMI Corp.--New Jersey) will also work in similar concentrations. The ceramic substrate was then rinsed twice in tap water for one minute per rinse.

After being dipped in the palladium activator solution and rinsed, the palladium deposited on the ceramic substrate was reduced in Reducer WA by Schering, AG for four minutes at

- 17 -

approximately 90°F in order to reduce the palladium from the ionic state of $Pd^{2+}$ to Pd metal. Thereafter, the ceramic substrates were dipped into a weaker reducing solution, with approximately one-tenth of the concentration of the previous bath to serve as a drag-in for the electroless copper bath.

A solution of Sodium Borohydrate at a concentration of 50 g/l and at 120°F will also reduce the Palladium. In addition, a product such as B100 stabilizer from Sel-Rex (New Jersey) will also work.

Next, the ceramic substrates were introduced into the electroless copper bath, which is sold by Schering under the name Noviganth HC. The electroless copper bath had approximately the following compositions:

    formaldehyde, 5 g/l
    sodium hydroxide, 10 g/l
    copper, 30 ml/l of addition agent
    stabilizer, 5% of addition agent
    cyanide 5 ppm and
    EDTA complexer

The electroless copper bath sold by McDermid (Connecticut) will also work in the present process, if a similar chemical composition is used.

After being in the electroless copper bath for approximately five minutes at 90°F, the ceramic substrate was then removed and rinsed for thirty seconds in deionized water. Thereafter, the ceramic substrate was twice again run through the sequence of steps starting with the predip solution and continuing through the palladium activator solution, two rinses, reducer and electroless bath in order to

- 18 -

deposit the desired thickness of copper. Using the present method of depositing copper, approximately 0.000050 inches of electroless copper was deposited on the ceramic substrate.

After being processed through the above steps a total of three times, the ceramic substrate was then subjected to a final rinse with deionized water for three to five minutes. The substrate was then dipped in a citric acid/sulfuric acid dip with a concentration of 5 g/l citric acid granules and a concentration of 10 ml/l $H_2SO_4$ for approximately three minutes to make the surface of the deposited copper anti-tarnish. The substrate was then rinsed with deionized water for one to two minutes and allowed to dry.

The ceramic substrate was next baked at 250°F for approximately two hours to remove any entrapped moisture from the deposited copper. Thereafter, the copper substrate was cleaned for approximately three minutes in a cleaner sold under the name Posiclean by Chemelex, Inc. (Milwaukee, Wisconsin) to remove any unwanted surface contaminants. The substrate was then rinsed with tap water. If desired, the balance of the required copper thickness may be deposited by either electroless or electrolitic plating.

In order to begin the electroplating steps, the copper-covered substrate was dipped in a ten percent sulfuric acid dip as a pre-dip. The ceramic substrate was then plated in a first acid electroplating bath made up of approximately 1.5 oz/gal of copper, 32 oz/gal sulfuric acid, 60 ppm of chloride and no brighteners. The electroplating was done at room temperature with a current density of approximately 10 amperes per square foot. The ceramic substrate was plated in this first electroplating bath for approximately five minutes. Thereafter, the ceramic substrate was electroplated in a second electroplating bath including brighteners (approximately 1 percent) with a lower concentration of copper 1.5 oz/gal and a higher concentration of sulfuric acid 30-35 oz/gal to allow for increased hole penetration of the copper. The chloride concentration of both baths was between 50 and 70 ppm. Thereafter, the ceramic substrate was spray rinsed with tap water and dipped in a citric acid/sulfuric acid dip with the same concentrations as above to once again make the surface of the copper tarnish resistant. Thereafter, the substrate was rinsed and once again dried.

Although the present invention has been described with reference to preferred embodiments, workers skilled in the art will recognize that changes may be made in form and detail without departing from the spirit and scope of the invention.

## CLAIMS:

1. A method of depositing a metal on a surface, comprising the steps of:

    exposing surface to an acid etchant;

    exposing the surface to an alkaline solution having a concentration of palladium of about 50 to about 200 ppm;

    exposing the surface to an electroless bath to deposit a layer of metal on the surface; and

    electroplating onto the metal on the surface additional metal.

2. The method of claim 1 wherein the alkaline solution does not contain tin.

3. The method of claim 1 or 2 wherein the electroless bath is an electroless copper bath.

4. The method of claim 3 wherein the electroless bath has a concentration of copper of about 1.0 to 2.0 g/l and preferably of about 1.5 g/l.

5. A method of depositing a metal on a surface of a ceramic substrate, comprising the steps of:

    exposing the surface to an activator soluting having a concentration of palladium of about 50 ppm to about 200 ppm;

    exposing the surface to an electroless bath to deposit a layer of metal on the surface; and

    electroplating onto the metal on the surface additional metal.

6. The method of claim 5 wherein the activator solution is alkaline.

7. The method of any one of the preceding claims wherein the electroplating step comprises the steps of:

    depositing a first electroplated layer of metal having a density greater than that of the layer deposited by the electroless bath; and depositing a second electroplated layer of metal having a density greater than that of the first electroplated layer.

8. A method of depositing a metal on a surface, comprising the steps of:
electrolessly depositing a layer of metal on the surface;
depositing a first electroplated layer of metal having a density greater than that of the layer deposited by the electroless bath; and
depositing a second electroplated layer of metal having a density greater than that of the first electroplated layer.

9. The method of claim 7 or 8 wherein the first electroplated layer is deposited in a first plating bath containing no brightners and the second electroplated layer is deposited in a second plating bath containing brightners.

10. The method of any one of claims 1 to 7, further comprising the step of:
exposing the surface to a solution of citric acid and sulfuric acid after the metal is deposited by the electroless bath.

11. The method of claim 8 and further comprising the step of:
exposing the surface to a solution of citric acid and sulfuric acid after electrolessly depositing the layer of metal for making the metal tarnish-resistant.

12. The method of claim 8 and further comprising the step of:
exposing the surface to a solution of citric acid and sulfuric acid after depositing the second electroplating layer for making the metal tarnish-resistant.

13. A method of depositing a metal on a surface, comprising the steps of:
exposing the surface to an acid etchant;
exposing the surface to an alkaline solution having a concentration of palladium of about 50 to about 200 ppm;
exposing the surface to an electroless bath to deposit a layer of metal on the surface; and
electroplating onto the metal on the surface additional metal.

14. The method of claim 13 wherein the acid etchant is a hydrogen halide.

15. The method of claim 13 wherein the acid etchant is phosphoric acid.

16. The method of claim 13 wherein the acid etchant is nitric acid.

17. The method of claim 13 wherein the acid etchant is permanganic acid.

18. The method of any one of the preceding claims wherein the metal is copper.

European Patent
Office

# EUROPEAN SEARCH REPORT

. Application number

| | DOCUMENTS CONSIDERED TO BE RELEVANT | | EP 87110236.4 |
|---|---|---|---|

| Category | Citation of document with indication, where appropriate, of relevant passages | Relevant to claim | CLASSIFICATION OF THE APPLICATION (Int. Cl.4) |
|---|---|---|---|
| X | DE - A1 - 3 125 730 (SIEMENS AG). <br> * Claim * <br> -- | 1,3,5, 13,16, 18 | C 25 D 5/10 <br> C 23 F 1/16 <br> C 23 C 22/78 |
| A | CHEMICAL ABSTRACTS, vol. 99, no. 20, November 14, 1983, Columbus, Ohio, USA <br> OGASAWARA, KANZO "Coating of tiles with metals" <br> page 260, column 1 <br> * Abstract-no. 162 711d (OGASAWARA KANZO) * <br> ---- | 1,3,5, 13,14, 18 | C 04 B 41/88 <br> H 05 K 3/18 |

TECHNICAL FIELDS
SEARCHED (Int. Cl.4)

C 25 D

C 23 F

C 23 C

C 04 B

H 05 K

The present search report has been drawn up for all claims

| Place of search | Date of completion of the search | Examiner |
|---|---|---|
| VIENNA | 14-10-1987 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03 82